**Europäisches Patentamt**

**European Patent Office**

**Office européen des brevets**

(11) Veröffentlichungsnummer: **0 259 791**

**A1**

(12) **EUROPÄISCHE PATENTANMELDUNG**

(21) Anmeldenummer: **87112917.7**

(22) Anmeldetag: **04.09.87**

(51) Int. Cl.⁴: **C23C 16/26** , C23C 16/02 , C23C 16/22 , B32B 15/04

(30) Priorität: **06.09.86 DE 3630418**

(43) Veröffentlichungstag der Anmeldung: **16.03.88 Patentblatt 88/11**

(84) Benannte Vertragsstaaten: **CH FR GB IT LI SE**

(71) Anmelder: **Kernforschungsanlage Jülich Gesellschaft mit beschränkter Haftung Postfach 1913 D-5170 Jülich 1(DE)**

(72) Erfinder: **Winter, Jörg, Dr. Auestrasse 36 D-5162 Niederzier(DE)**
Erfinder: **Esser, Hans-Günter Kapellenstrasse 13 D-5172 Linnich-Ederen(DE)**
Erfinder: **Waelbroeck, Francois, Prof. Mannheimer Strasse 4 D-5170 Jülich(DE)**
Erfinder: **Wienhold, Peter, Dr. Rurallee 7 D-5172 Linnich(DE)**

(54) **Verfahren zur Herstellung von Werkstücken mit einer Oberflächenschicht aus Kohlenstoff.**

(57) Die Erfindung bezieht sich auf ein Verfahren zur Beschichtung von Werkstücken mit amorphem, wasserstoffhaltigem Kohlenstoff, bei dem zur besseren Haftung der Kohlenstoffschicht zunächst eine Zwischenschicht mit einem Haftvermittler auf das Werkstück aufgebracht wird. Gemäß der Erfindung werden als Material für die Zwischenschicht Metalle genannt. In zweckmäßiger Ausgestaltung des Verfahrens gemäß der Erfindung werden Verfahrensschritte zur Reinigung der zu beschichtenden Oberfläche angewendet, wobei diese Oberflächen einem Wasserstoffatome und/oder -ionen enthaltenden Wasserstoffstrom ausgesetzt werden.

EP 0 259 791 A1

# Verfahren zur Herstellung von Werkstücken mit einer Oberflächenshicht aus Kohlenstoff

Die Erfindung bezieht sich auf ein Verfahren zur Herstellung von Werkstücken mit einer Oberflächenschicht aus amorphem, wasserstoffhaltigem Kohlenstoff.

Das Aufbringen einer amorphen, wasserstoffhaltigen Kohlenstoffschicht auf Werkstücke ist bekannt. Es hat sich jedoch gezeigt, daß es nicht bei allen Werkstück-Materialien gelingt, eine gut haftende Kohlestoffschicht aufzubringen. Vielmehr lösen sich zum Teil schon nach kurzer Zeit Kohlenstoffschichten, die beispielsweise auf Materialien wie Nickel, Eisen oder Inconel aufgetragen worden sind.

Es ist Aufgabe der Erfindung, ein Verfahren der eingangs bezeichneten Art zu schaffen, nach dem eine gut haftende amorphe, wasserstoffhaltige Kohlenstoffschicht auch auf Materialien aufbringbar ist, auf denen die Kohlenstoffschicht aufgrund der Materialeigenschaften des Materials des Werkstückes schlecht haftet.

Diese Aufgabe wird gemäß der Erfindung dadurch gelöst, daß bei Werkstücken aus einem Material mit schlechter Haftung für die Kohlenstoffschicht auf die Oberfläche des Werkstückes zunächst eine Zwischenschicht aus einem Material mit guter Haftung für die Kohlenstoffschicht und anschließend auf die Zwischenschicht die Kohlenstoffschicht aufgebracht wird.

Dabei hat sich als vorteilhaft erwiesen, daß als Material für die Zwischenschicht Wolfram, Chrom, Titan, Silicium, Palladium oder Molybdän vorgesehen ist.

Das Auftragen der Zwischenschicht kann nach geeigneten Verfahren, z.B. durch Elektrolyse, durch Aufdampfen im Vakuum, durch Zerstäuben oder andere Verfahren der Anreicherung des Zwischenschichtmaterials an der zu belegenden Oberfläche erfolgen.

Um eine möglichst hinreichende Belegung der Oberfläche zu erreichen, sollte die Dicke der Zwischenschicht wenigstens 10 Angström betragen.

Zur Erzielung einer guten Haftung der Kohlenstoffschicht ist es erforderlich, daß die Oberfläche der Zwischenschicht vor dem Auftrag der Kohlenstoffschicht möglichst frei von Oberflächenverunreinigungen ist.

Für den Fall, daß der Auftrag des Materials der Zwischenschicht dim Vakuum erfolgt (beispielsweise durch Verdampfen oder Zerstäuben) und der Auftrag der Kohlenstoffschicht in situ, d.h. anschließend in derselben Apparatur, erfolgt, kann ein separater Reinigungsschritt für die Oberfläche der Zwischenschicht entfallen, insbesondere dann, wenn zuvor die zu belegende Oberfläche des Werkstückes gereinigt worden war. Ansonsten ist die Oberfläche der Zwischenschicht vor dem Auftrag der Kohlenstoffschicht zu reinigen.

Zur Entfernung von Oberflächenverunreinigungen wird die Oberfläche des Werkstückes und/oder der Zwischenschicht zur Reduktion der Oberflächenverunreinigungen, die mit atomarem Wasserstoff oder niederenergetischen Wasserstoffionen eine Verbindung eingehen, wie beispielsweise Sauerstoff, Kohlenstoff, Chlor, Fluor und Schwefel unter einem Druck von $10^{-2}$ bis $10^2$ Pa einem Wasserstoffatom und/oder -ionen enthaltenden Wasserstoffstrom ausgesetzt, wobei aus dem Wasserstoffstrom Wasserstoffatome und/oder Wasserstoffionen durch Kontaktdissoziation an heißen Flächen oder mittels Glimmentladung oder durch Elektronenzyklotronresonanz gebildet werden, die mit der zu reinigenden Oberfläche in Kontakt gebracht werden, und wobei die gebildeten flüchtigen Verbindungen abgepumpt werden.

Es kann aber auch zweckmäßig sein, daß die zu belegende Oberfläche des Werkstückes und/oder der Zwischenschicht zur Reduktion der Oberflächenverunreinigungen unter einem Druck von $10^{-2}$ bis $10^2$ Pa und einer Temperatur im Bereich von 10°C bis maximal 100°C einem Wasserstoffatom und/oder -ionen enthaltenden Wasserstoffstrom mit einem Anteil von 0,1 % bis 3 Vol% Methan ausgesetzt werden, wobei aus dem Wasserstoffstrom Wasserstoffatome und/oder Wasserstoffionen und Kohlenwasserstoffionen durch Kontaktdissoziation an heißen Flächen oder mittels Glimmentladung oder durch Elektronenzyklotronresonanz gebildet werden, die mit der zu reinigenden Oberfläche in Kontakt gebracht werden, und wobei die gebildeten flüchtigen Verbindungen abgepumpt werden. Der als Verunreinigung auf der Oberfläche befindliche Sauerstoff wird dabei bevorzugt in Verbindung mit Kohlenstoff als CO entfernt.

Bei der Durchführung dieser Verfahrensweise können als heiße Flächen beispielsweise Fäden oder Wendeln aus Wolfram, Rehenium oder Tantal verwendet werden.

Die Ausrichtung der Wasserstoffatome und/oder Ionen oder auch der Kohlenwasserstoffionen auf die zu reinigende Fläche kann mittels eines elektrischen Feldes oder durch eine geeignete Geometrie des Behälters, in welchem sich das Werkstück bei der Reinigung befindet, erreicht werden, so daß die Atome und/oder Ionen die zu reinigende Oberfläche erreichen.

Hinsichtlich des Abtransports der entstehenden flüchtigen Verbindungen ist dafür Sorge zu tragen, daß eine im Hinblick auf die Entstehungsrate der Verbindungen ausreichende Saugleistung vorgesehen ist, damit erreicht wird, daß die entstandenen Verbindungen abgepumpt werden.

Als zweckmäßig hat sich erwiesen, daß die Stromdichte des auf die Oberfläche gerichteten Atome bzw. Ionenstroms einige $\mu$A/cm$^2$ bis einige 100 $\mu$A/cm$^2$ beträgt und daß diese Stromdichte wenigstens eine halbe Stunde lang aufrechterhalten wird.

Zur Auftragung der amorphen, wasserstoffhaltigen Kohlenstoffschicht wird die Oberfläche der Zwischenschicht unter einem Druck von 10$^{-2}$ bis 10$^2$ Pa einem Kohlenwasserstoffionen-Strom ausgesetzt, wobei die Kohlenwasserstoffionen in einer Glimmentladung oder durch Elektronenzyklotronresonanz erzeugt und auf die zu belegende Oberfläche der Zwischenschicht gerichtet werden. Die Ausrichtung der Kohlenwasserstoffionen kann dabei durch ein elektrisches Feld erreicht werden oder auch, da eine Energie der Ionen von etwa 10 eV beim Auftreffen auf die Wandung ausreichend ist, durch geeignete Wahl der Geometrie des Behälters, in welchem sich das Werkstück bei der Auftragung der Schicht befindet, so daß die Ionen die Oberfläche der Zwischenschicht erreichen.

Der in den Behälter eingespeiste Kohlenwasserstoff kann dabei reines Methan sein, jedoch wird zweckmäßigerweise ein Methan-Wasserstoffgemisch (wobei im Wasserstoffanteil auch Deuterium und Tritium enthalten sein kann) verwendet, wobei der Anteil des Methans mindestens 3 Vol% beträgt.

## Ausführungsbeispiel 1

Eine Probe aus Nickel mit den Abmessungen 20 mm x 20 mm x 1 mm wurde in ein Vakuumgefäß gebracht, das von Wasserstoff unter einem Arbeitsdruck von 10$^{-1}$ Pa durchströmt wurde und in dem eine Glimmentladung aufrechterhalten wurde. Die Probe war als Kathode geschaltet und wurde mittels einer separaten elektrischen Widerstandsheizung auf eine Temperatur von 300 °C gehalten. Diese Reinigung der Oberfläche wurde etwa eine halbe Stunde lang durchgeführt.

Auf die gereinigte Oberfläche wurde Molybdän mit einer Schichtdicke von ca. 100 Angström gestäubt.

Anschließend wurde unter sonst gleichen Bedingungen wie bei der Reinigung der Oberfläche an Stelle des Wasserstoffs ein Wasserstoff-Methan-Gemisch (Methananteil 15 Vol%) in das Vakuumgefäß einströmen gelassen. Auf der Molybdänoberfläche schied sich dann eine amorphe, wasserstoffhaltige Kohlenstoffschicht ab, die nach einer Betriebsdauer von 5 Stunden eine Dicke von 1000 Angström aufwies.

Die so aufgebrachte Kohlenstoffschicht löst sich nicht von der Unterlage, sie ist beispielsweise wisch-und kratzfest, was bei einem direkten Auftrag der Kohlenstoffschicht auf die Nickelprobe nicht der Fall ist.

## Ausführungsbeispiel 2

Die Reinigung der Probe und der Auftrag der Zwischenschicht sowie der Auftrag der Kohlenstoffschicht wurden in der gleichen Weise, wie in Ausführungsbeispiel 1 beschrieben, vorgenommen. An Stelle der Nickelprobe wurde jedoch eine Probe aus Inconel verwendet und eine Zwischenschicht aus Palladium aufgetragen.

Die auf die Inconelprobe aufgetragene Kohlenstoffschicht haftete ebenso gut auf der Unterlage wie bei der im Ausführungsbeispiel 1 beschriebenen Probe.

## Ansprüche

1. Verfahren zur Herstellung von Werkstücken mit einer Oberflachenschicht aus amorphem, wasserstoffhaltigem Kohlenstoff,
**dadurch gekennzeichnet,**
daß bei Werkstücken aus einem Material mit - schlechter Haftung für die Kohlenstoffschicht auf die Oberfläche des Werkstückes zunächst eine Zwischenschicht aus einem Material mit guter Haftung für die Kohlenstoffschicht und anschließend auf die Zwischenschicht die Kohlenstoffschicht aufgebracht wird.

2. Verfahren nach Anspruch 1,
**dadurch gekennzeichnet,**
daß als Material für die Zwischenschicht Wolfram, Chrom, Titan, Silicium, Palladium oder Molybdän vorgesehen ist.

3. Verfahren nach Anspruch 1 oder 2,
**dadurch gekennzeichnet,**
daß die Dicke der Zwischenschicht wenigstens 10 Ångström beträgt.

4. Verfahren nach einem der Ansprüche 1 bis 3,
**dadurch gekennzeichnet,**
daß die zu belegende Oberfläche des Werkstückes und/oder der Zwischenschicht zur Reduktion der Oberflächenverunreinigungen unter einem Druck von 10$^{-2}$ bis 10$^2$ Pa und einer Temperatur von 100 °C bis 600 °C, bevorzugt etwa 300 °C, einem Wasserstoffatom und/oder -ionen enthaltenden Wasserstoffstrom ausgesetzt wird, wobei aus dem Wasserstoffstrom Wasserstoffatome und/oder Wasserstoffionen durch Kontaktdissoziation an heißen Flächen oder mittels Glimmentladung oder durch Elektronenzyklotronresonanz gebildet werden, die mit der zu reinigenden Oberfläche in Kontakt gebracht werden, und wobei die gebildeten flüchtigen Verbindungen abgepumpt werden.

5. Verfahren nach einem der Ansprüche 1 bis 3,

**dadurch gekennzeichnet,**

daß die zu belegende Oberfläche des Werkstückes und/oder der Zwischenschicht zur Reduktion der Oberflächenverunreinigungen unter einem Druck von $10^{-2}$ bis $10^2$ Pa und einer Temperatur im Bereich von 10°C bis maximal 100°C einem Wasserstoffatom und/oder -ionen enthaltenden Wasserstoffstrom mit einem Anteil von 0,1 % bis 3 Vol% Methan ausgesetzt werden, wobei aus dem Gasstrom Wasserstoffatome und/oder Wasserstoffionen und Kohlenwasserstoffionen durch Kontaktdissoziation an heißen Flächen oder mittels Glimmentladung oder durch Elektronenzyklotronresonanz gebildet werden, die mit der zu reinigenden Oberfläche in Kontakt gebracht werden, und wobei die gebildeten flüchtigen Verbindungen abgepumpt werden.

6. Verfahren nach Anspruch 4 oder 5,

**dadurch gekennzeichnet,** .

daß die Stromdichte des auf die Oberfläche gerichteten Atome-bzw. Ionenstroms einige $\mu A/cm^2$ bis 100 $\mu A/cm^2$ beträgt.

7. Verfahren nach einem der Ansprüche 1 bis 6,

**dadurch gekennzeichnet,**

daß die Oberfläche der Zwischenschicht zur Auftragung der amorphen, wasserstoffhaltigen Kohlenstoffschicht unter einem Druck von $10^{-2}$ bis $10^2$ Pa einem Kohlenwasserstoffionenstrom ausgesetzt wird, wobei die Kohlenwasserstoffionen in einer Glimmentladung oder durch Elektronenzyklotronresonanz erzeugt und auf die zu beladende Oberfläche der Zwischenschicht gerichtet werden.

## EINSCHLÄGIGE DOKUMENTE

EP 87112917.7

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | DE - A1 - 2 604 019 (PHILIPS PATENTVERWALTUNG GMBH) <br><br> * Seite 7, Zeilen 8-11; Patentansprüche * <br><br> -- | 1 | C 23 C 16/26 <br> C 23 C 16/02 <br> C 23 C 16/22 <br> B 32 B 15/04 |
| Y | WO - A1 - 86/00 093 (BATTELLE-INSTITUT E.V.) <br><br> * Patentansprüche * <br><br> -- | 1 | |
| A | EP - A1 - 0 142 176 (G.G. MERKL) <br><br> * Patentansprüche * <br><br> -- | 1 | |
| A | DE - A1 - 3 442 208 (LEYBOLD-HERAEUS GMBH) <br><br> * Patentansprüche * <br><br> -- | 1 | |
| A` | EP - A2 - 0 183 254 (MATSUSHITA ELECTRIC INDUSTRIAL CO., LTD.) <br><br> * Patentansprüche; Zusammenfassung * <br><br> -- | 1 | **RECHERCHIERTE SACHGEBIETE (Int. Cl.4)** <br><br> C 23 C <br> B 32 B |
| A | AU - B - 457 605 (C.I. HAYES INC.) <br><br> * Patentansprüche * <br><br> ---- | 1 | |

Der vorliegende Recherchenbericht wurde für alle Patentansprüche erstellt.

| Recherchenort | Abschlußdatum der Recherche | Prüfer |
|---|---|---|
| WIEN | 27-11-1987 | SLAMA |